Europäisches Patentamt

European Patent Office

Office européen des brevets

(11) Publication number: **0 313 381**
**A2**

# EUROPEAN PATENT APPLICATION

(21) Application number: **88309915.2**

(22) Date of filing: **21.10.88**

(51) Int. Cl.4: **H 04 N 1/028**

(30) Priority: **21.10.87 JP 266098/87**
**21.10.87 JP 266099/87**
**21.10.87 JP 266100/87**

(43) Date of publication of application:
**26.04.89 Bulletin 89/17**

(84) Designated Contracting States: **DE FR GB**

(71) Applicant: **SEMICONDUCTOR ENERGY LABORATORY CO., LTD.**
**398 Hase**
**Atsugi-shi Kanagawa-ken, 243 (JP)**

(72) Inventor: **Yamazaki, Shunpei**
**21-21 Kitakarasuyama 7-chome**
**Satagaya-ku Tokyo (JP)**

**Fukada, Takeshi**
**3-31 Sugikubo 2589**
**Ebina-shi Kanagawa-ken (JP)**

**Sakama, Mitsunori**
**Kamiyoshizawa 1173**
**Hiratsuka-shi Kanagawa-ken (JP)**

**Shinohara, Hisato**
**15-8 Seishin 5**
**Sagamihara-shi Kanagawa-ken (JP)**

**Amachi, Nobumitsu**
**Flat Atsugi 108 Hase 931-1**
**Atsugi-shi Kanagawa-ken (JP)**

**Sakamoto, Naoya**
**Flat Atsugi 203 Hase 931-1**
**Atsugi-shi Kanagawa-ken (JP)**

**Inuzima, Takashi**
**Morinosato 1-29-2-204**
**Atsugi-shi Kanagawa-ken (JP)**

(74) Representative: **Milhench, Howard Leslie et al**
**R.G.C. Jenkins & Co. 26 Caxton Street**
**London SW1H 0RJ (GB)**

(54) Image sensor.

(57) An improved contact type image sensor comprises a glass substrate, a light blocking electrode formed on the glass substrate, a photosensitive semiconductor film formed on the electrode, and a transparent electrode formed on the semiconductor film. A light window is opened through the semiconductor device and through the light blocking electrode. On the light path including the light window, an uneven lenticular interface is formed in order that light transmitted through the light window for illuminating an original image carrier will give rise to reflected light incident on the photosensitive semicondcutor after reflection from the surface of the original.

F I G. 3

## Description

### Image Sensor

### BACKGROUND OF THE INVENTION

The present invention relates to an image sensor and particularly a contact type image sensor. Such image sensors are utilized in facsimile apparatus for example.

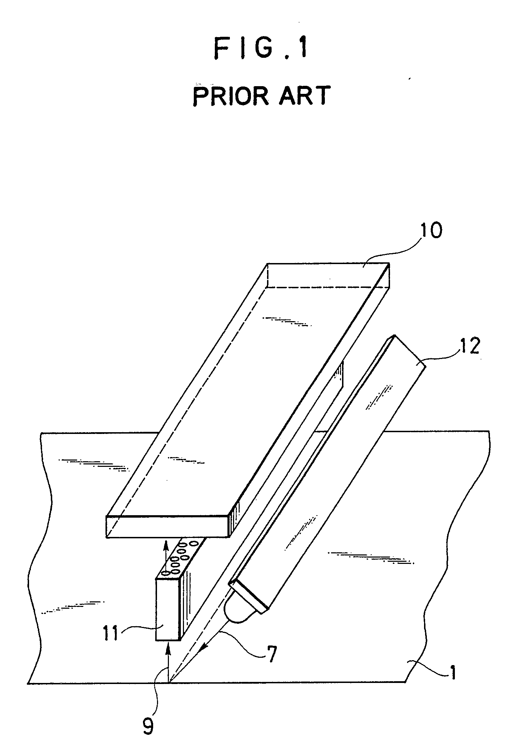

There are two classes of contact type image sensors from the view point of their construction. One class of prior art image sensor is schematically represented by the arrangement shown in Fig.1 of the accompanying drawings. The sensor of Fig.1 comprises a photosensor 10, a light source 12 extending parallel to the photosensor 10 and a lens 11 located so as to focus light rays emitted from the light source 12 and reflected from an image carrying original 1 to the photosensor 10. The size and weight of image sensors of this type are increased by provision of the lens.

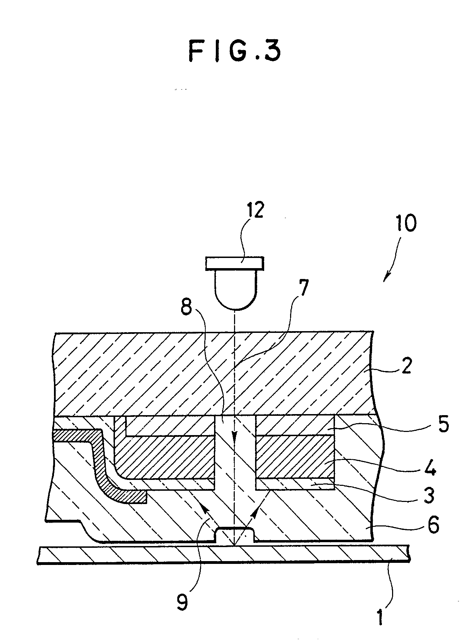

The operation of the other type of contact image sensors may be understood from Fig.3 of the accompanying drawings which illustrates an embodiment of the present invention. In this construction, a photosensitive semiconductor device consisting of a pair of electrodes 3 and 5 and a semiconductor film 4 therebetween is formed on a glass substrate 2. A window 8 is opened through the semiconductor device in order to allow light from a light source 12 located behind the glass substrate 2 to pass to the opposite side of the sensor. A transparent insulating film coating 6 is provided over the photosensitive device. In operation, the device is placed on and makes contact with the surface of an original 1. Light rays pass through the window 8, are reflected from the original 1, and are sensed by the photosensitive semiconductor device. In the prior art, a large number of manufacturing steps in photolithography have been required for producing prior art devices of this general type and therefore the production cost has been high.

### OBJECTS AND SUMMARY OF THE INVENTION

It is an object of the present invention therefore to provide an image sensor of the second type abovementioned which is relatively inexpensive to manufacture. Another object is to provide such a device which is substantially immune to the influence of incident light rays which are not reflected from an original.

According to one aspect of the invention there is provided an image sensor comprising a substrate, a photosensitive semiconductor layer on said substrate, first and second electrodes in contact with opposed surfaces of said semiconductor layer, one of said electrodes being transparent and the other being opaque and/or having an opaque coating, and a light window opened in said semiconductor layer and in said opaque electrode and/or coating, the arrangement being such that light projected through said window onto an image bearing sheet is prevented from impinging onto said semiconductor layer directly by virtue of the provision of said opaque electrode and/or coating but can impinge upon said semiconductor layer via the transparent electrode after reflection from the surface of a juxtaposed image carrier.

According to another aspect the invention provides an image sensor comprising: a transparent substrate; a photosensitive semiconductor layer on said substrate; first and second electrodes in contact with opposed surfaces of said semiconductor layer, the electrode located on one side of said semiconductor layer being light blocking and the other electrode being transparent; and a light window opened in said light blocking electrode and said photosensitive layer.

Yet another aspect of the invention provides a method of manufacturing an image sensor, said method comprising: forming a photosensitive semiconductor layer upon a light-transparent substrate with the semiconductor layer sandwiched between first and second electrodes, one of said electrodes being transparent and the other being opaque and/or having an opaque coating, and forming a light window through said semiconductor layer and through said opaque electrode/coating.

Further features aspects and advantages of the invention are set forth with particularity in the appended claims and will become apparent to those possessed of the relevant skills from consideration of the following description given with reference to the accompanying drawings.

### BRIEF DESCRIPTION OF THE DRAWINGS

Fig.1 is a perspective view showing a prior art image sensor;

Figs.2(A) to (D) are cross-sectional views showing the procedure for manufacturing an exemplary image sensor in accordance with the present invention;

Fig.3 is an explanatory showing of the operation of an image sensor in accordance with the present invention;

Figs.4(A) to 4(C) are plan views showing different examples of patterns of light windows that might be provided in an image sensor in accordance with the present invention;

Fig.5 is a cross-sectional view showing a modification of the sensor illustrated in Figs.2(A) to 2(D);

Figs.6(A) to 6(C) are cross-sectional views showing another embodiment of the present invention;

Fig.7 is a cross-sectional view showing a modification of the sensor illustrated in Figs.6(A) to 6(C); and

Figs.8(A) and 8(B) are respectively cross-sectional and plan views showing a further embodiment of the present invention.

## DETAILED DESCRIPTION OF THE EMBODIMENTS

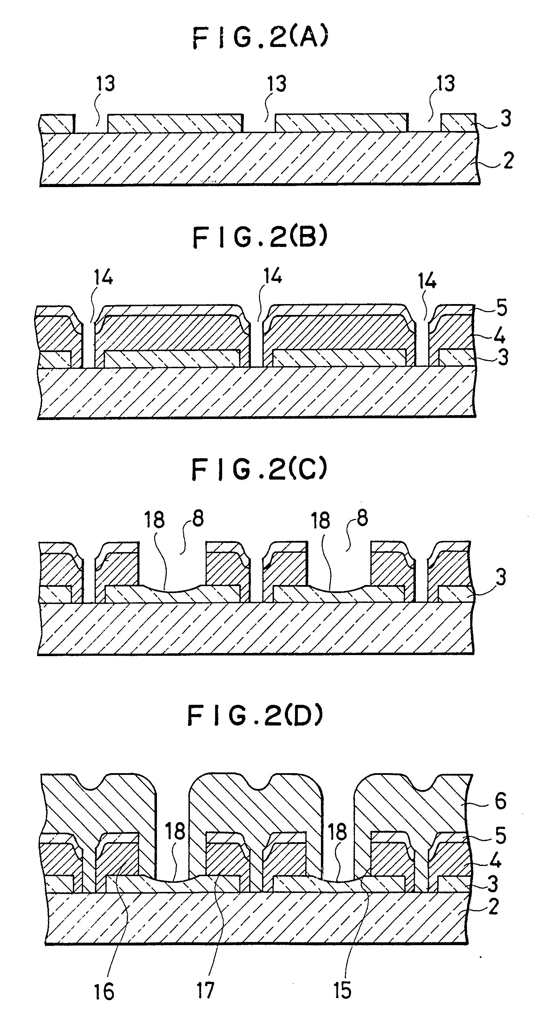

Referring now to Figs.2(A) to 2(D), a method of manufacturing image sensors in accordance with the present invention is illustrated therein and will hereinafter be described.

A transparent $SnO_2$ film 3 of 0.5-0.6 micron thickness is first formed on a transparent glass substrate 2 by a conventional CVD method. The $SnO_2$ film 3 is then severed into a plurality of transparent electrodes of 125 microns width and 100 microns length by laser scribing utilizing a KrF excimer laser in order to form grooves 13. The distance between adjacent electrodes is 50 microns. A photosensitive amorphous silicon semiconductor film comprising an NIN junction is then formed on the substrate 2 over the electrodes by a conventional plasma CVD. The deposition conditions for the formation of the semiconductor film were as follows:

| [N-type] | precursor gases; | $PH_3/SiH_4$ | 0.5% 5 SCCM |
| | | $SiH_4$ | 100% 100 SCCM |
| | pressure; | 0.1 Torr | |
| | electric power; | 20W (13.56 MHz) | |
| | substrate temperature; | 250°C | |
| [I-type] | precursor gases; | $SiH_4$ | 100% 100 SCCM |
| | (other conditions are identical to those of N-type) | | |

Molybdenum light-blocking film 5 of 0.2 micron thickness is formed on the semicondcutor film 4, followed by laser scribing to cut grooves 14 through the thicknesses of the molybdenum film 5 and the semiconductor film 4, in alignment with the grooves 13 but with a width of only 10 microns. By means of this scribing, a plurality of separated sensing cell elements are formed. This laser scribing is performed also with a KrF excimer laser. Next, a portion of each separated film 4 and overlying electrode portions 5 is removed by laser scribing in the same manner in order to open a light window 8. The laser scribing is effected also on the surfaces of the underlying transparent electrodes 3 in order to form concave lenticular surfaces therein.

Finally, an opaque epoxy resin layer is coated over the structure by a screen press printing technique so as to leave the light windows 8 open and cause the side surfaces of the semiconductor films to be protected by the resin layer as shown in Fig.2(D).

The operation of the device of Fig.2 as thus constructed is substantially as explained above with reference to Fig.3 except that the device is used the other way up. Namely, an image bearing original is located in contact with the lower surface of the substrate 2, and a light source is located on the resin layer side of the device. Light rays incident on the device pass through the light windows 8, are reflected from the surface of an original 1 and are detected by the portions of photosensitive semiconductor film 4 adjacent to the windows 8.

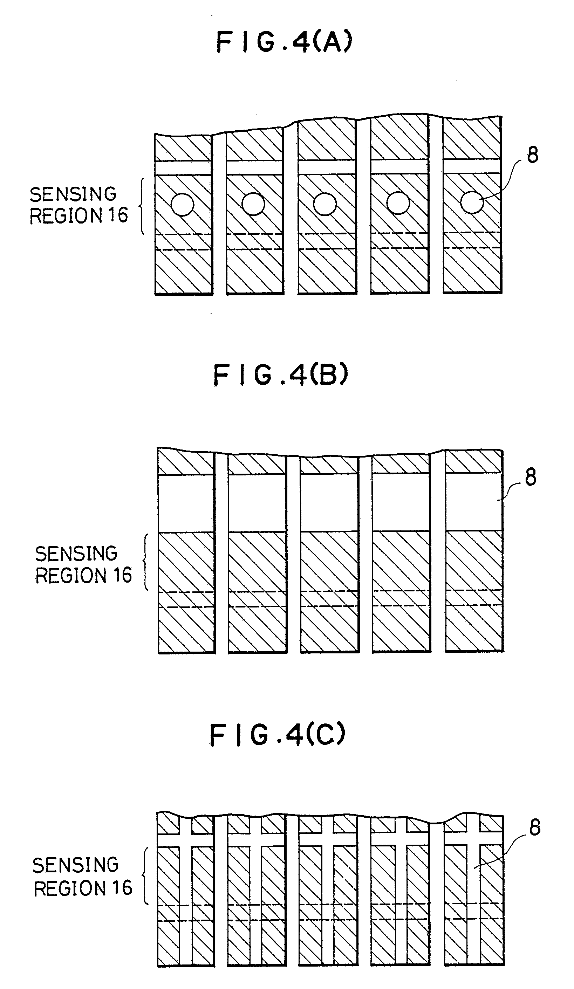

Figs.4(A) to 4(C) are plan views showing exemplary patterns of the windows 8. A circular window might be opened for each photosensitive cell as shown in Fig.4(A), and pulsed spot-focus laser beams are suitable for forming circular windows of this kind. Alternatively, since an excimer laser can emit a laser beam focussed with a uniform energy density into a cross-sectional area 10 microns thick and 100 mm wide, by use of such a laser beam a linear groove extending over a plurality of photosensitive cell elements can be formed in order to provide a window for each cell as illustrated in Fig.4(B). A linear groove may also be formed perpendicular to the case of Fig.4(B) to form light windows 8 as shown in Fig.4(C).

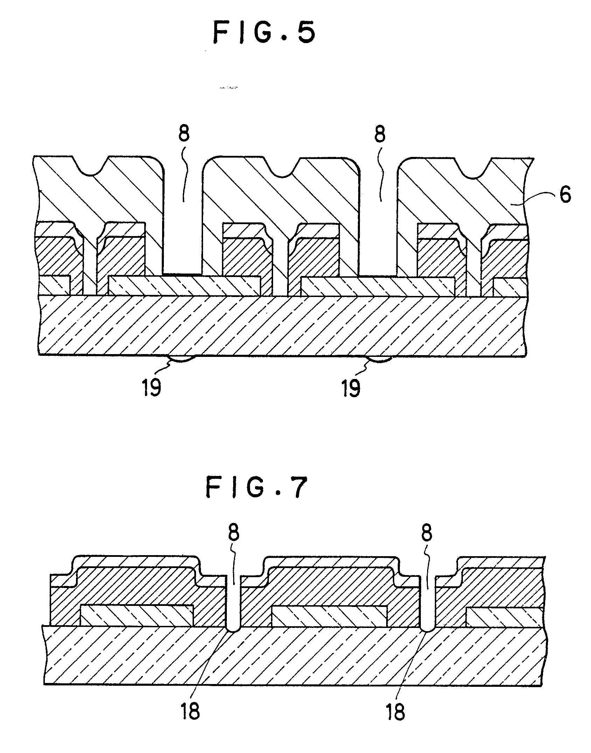

Fig.5 shows a modification of the embodiment of Figs.2(A) to 2(D). In this modification, the final laser scribing step of Figs.2(A) to 2(D) is stopped just at the upper surface of the transparent electrodes 3, and convex lenticular surfaces 19 are formed on the lower surface of the substrate 2 by depositing $SiO_2$ or other transparent material at locations in alignment with the light windows 8.

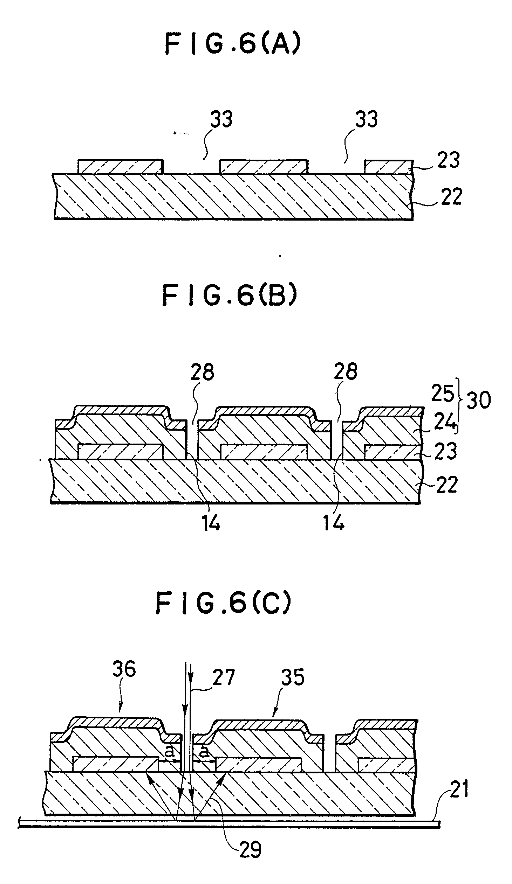

Referring to Figs.6(A) to 6(C), another embodiment of the present invention is illustrated therein. A $SnO_2$ film is deposited on a transparent substrate to a thickness of 0.5 - 0.6 micron by a known CVD method. The $SnO_2$ film 23 is severed by a KrF excimer laser into a plurality of transparent electrode segments 75 microns wide and 100 microns long as shown in Fig.6(A). The distance between adjacent electrodes is 50 microns. An NIN photosensitive amorphous silicon semiconductor film 24 of about 0.7 micron thickness is deposited on the substrate 22 over the transparent electrodes 23. The deposition conditions are the same as for the previous embodiment. Furthermore, a 0.2 micron thick molybdenum film 25 is deposited by a known sputtering technique.

At the centre positions between adjacent electrodes 23, the structure is irradiated with a laser beam in the same manner as in the previous embodiment to open light windows 28 as illustrated in Fig.6(B). The distance "a" between the side wall of the window and the neighbouring electrode 23 is chosen to be 20 microns in order to reduce the influence of carriers generated by light rays incident upon the semiconductor film 24 just adjacent to the windows without refelction from an original. The distance "a" is preferably wider than the thickness of the photosensitive semiconductor film. More specifically, the distance shold be chosen to be wider than the carrier diffusion length, approx. 2 microns in the case of amorphous silicon semiconductor material. The influence of non-reflected light rays was evaluated by measuring the power difference between the case of perfect dark conditions and the case of light rays being incident upon sensors having varied distances "a" without an original 21 being disposed adjacent the device. As a result, it was found that the differences were 1% for 20 microns and 5 microns, 3% for 2 microns and 15% for 1 micron. From this experiment, it was established that a distance not shorter than 2 microns was sufficient. When the thickness of the semiconductor film was varied from 0.3 micron to 1.5 microns, keeping the distance "a" at a constant 2 microns, the output differences obtained were 1 - 5%. The operation of the device of Figs.6(A) to 6(C) otherwise is substantially identical to that of the previous embodiment.

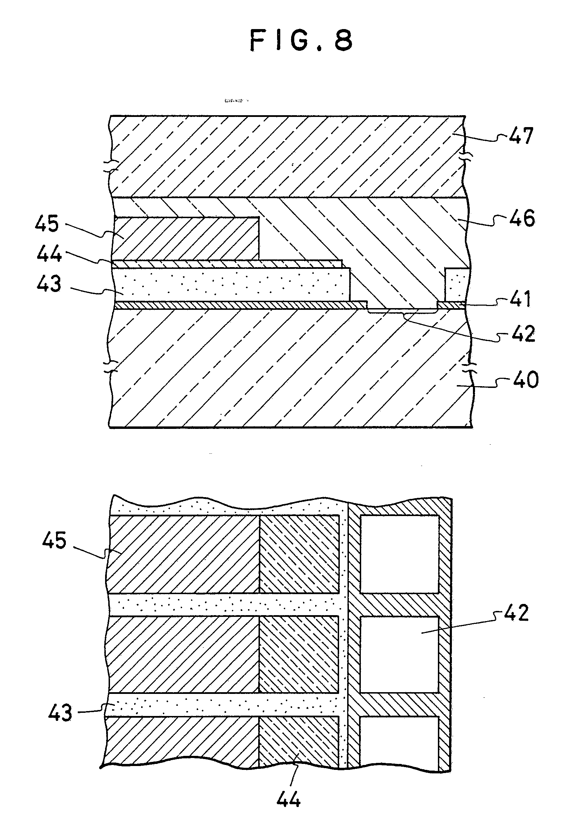

Fig.7 is a cross-sectional view showing a modification of the embodiment of Figs.6(A) to 6(C). In this modification, a portion of the substrate is removed when the light windows are opened by laser scribing in order to form concave lenticular surfaces 18. The provision of concave/convex surfaces, more generally uneven interfaces, on the light paths helps incident light rays to reach the photosensitive semiconductor film which would be displaced from the light paths if the light rays passed only in a straight line.

Referring to Figs.8(A) and 8(B), a further embodiment is illustrated therein. The image sensor of this embodiment comprises a 1.1 mm thick glass substrate 40, a chromium common electrode 41 in which light windows 42 are opened, an amorphous silicon semiconductor film 43 in which there are opened light windows which have an area larger than that of the window 42, ITO electrodes 44 extending near to the windows, Al electrodes 45 extending short of the windows along the ITO electrodes 44 in order that the end portions of the ITO electrodes 44 are spaced from the Al electrodes 45, a transparent adhesive layer 46 and a 50 microns glass substrate 48. In this embodiment, the films 41, 43, 44 and 45 are patterned by a conventional photoliothography process using photoresists. The ITO film is preferably baked after patterning. In operation of the device, an original is placed in contact with the thin glass substrate 47. Light rays pass through the window 42, are reflected from the original and are received by the amorphous semiconductor 43 between the window 42 and the end of the Al electrode 45.

While several embodiments have been specifically described, it is to be appreciated that the present invention is not limited to the particular examples described and that modifications and variations can be made without departure from the scope of the invention as defined by the appended claims.

## Claims

1. An image sensor comprising a substrate, a photosensitive semiconductor layer on said substrate, first and second electrodes in contact with opposed surfaces of said semiconductor layer, one of said electrodes being transparent and the other being opaque and/or having an opaque coating, and a light window opened in said semiconductor layer and in said opaque electrode and/or coating, the arrangement being such that light projected through said window onto an image bearing sheet is prevented from impinging onto said semiconductor layer directly by virtue of the provision of said opaque electrode and/or coating but can impinge upon said semiconductor layer via the transparent electrode after reflection from the surface of a juxtaposed image carrier.

2. An image sensor comprising: a transparent substrate; a photosensitive semiconductor layer on said substrate; first and second electrodes in contact with opposed surfaces of said semiconductor layer, the electrode located on one side of said semiconductor layer being light blocking and the other electrode being transparent; and a light window opened in said light blocking electrode and said photosensitive layer.

3. An image sensor of claim 2 wherein an uneven light-transparent interface is provided at a location in the path of light rays incident upon said sensor.

4. An image sensor of claim 2 or 3 wherein the distance between the perimeter of said light window and the edge of said transparent electrode nearest to said light window is less than the thickness of the semiconductor film.

5. An image sensor of claim 2 or 3 or 4 wherein the distance between the perimeter of said light window and the edge of said transparent electrode nearest to said light window is less than the carrier diffusion length in the semiconductor film.

6. An image sensor according to any of the preceding claims wherein the semiconductor layer and its associated electrodes are divided to define a plural array of photosensitive cells, and a light window is opened in each of said cells.

7. An image sensor according to any of the preceding claims and further including a light source for projecting light through said window(s).

8. A method of manufacturing an image sensor, said method comprising: forming a photosensitive semiconductor layer upon a light-transparent substrate with the semiconductor layer sandwiched between first and second electrodes, one of said electrodes being transparent and the other being opaque and/or having an opaque coating, and forming a light window through said semiconductor layer and through said opaque electrode/coating.

9. A method according to claim 8 which comprises dividing the semiconductor layer and its associated electrodes into a plural array of photosensitive cells, and forming a light window in each of said cells.

10. A method according to claim 8 or 9 wherein the forming of the light window(s) and/or the division of the semiconductor layer into a plural array of photosensitive cells is effected by means of a laser beam.

# F I G . 1

## PRIOR ART

## F I G.2(A)

## F I G.2(B)

## F I G.2(C)

## F I G.2(D)

# FIG.3

# F I G . 4(A)

SENSING
REGION 16

8

# F I G . 4(B)

SENSING
REGION 16

8

# F I G . 4(C)

SENSING
REGION 16

8

# FIG. 5

# FIG. 7

# FIG.6(A)

# FIG.6(B)

# FIG.6(C)

# FIG. 8